# EUROPEAN PATENT APPLICATION

(11) **EP 1 918 319 A2**
(43) Date of publication of application: **07.05.2008**
(21) Application number: 07119611.7
(22) Date of filing: 30.10.2007
(51) Int. Cl.: C08J 7/04

(54) **Gas barrier plastic body and gas barrier plastic film**

(30) Priority: 30.10.2006 JP 2006294423
(71) Applicant: Shin-Etsu Film Co., Ltd., Fukui, Echizen-shi (JP)
(72) Inventor: Hongu, Tatsuhiko, Chiyoda-ku Fukui (JP); Kenichi, Uesaka, Echizen-shi Fukui (JP)
(74) Representative: Schubert, Klemens

(57) **Abstract**

Films of a plastic resin such as a polyester film for packaging use can be imparted with improved gas barrier property or decreased permeability to gases such as water vapor and oxygen without decreasing pliability or flexibility and without degradation of the appearance and transparency so as to be useful as a packaging film for products having sensitivity to those gases. According to the invention, a plastic film is provided on at least one surface with a vapor-deposited layer of amorphous silicon of 10 to 200 nm thickness. The vapor deposition process is carried out preferably by a chemical vapor deposition method using silane and hydrogen as the reactant gases The gas permeability can be further decreased by a heat treatment of the amorphous silicon layer at 70 to 140 °C.

## Description

### BACKGROUND OF THE INVENTION

### 1. Field of the Invention

The present invention relates to a plastic body and a plastic film having excellent gas-barrier property, and more particularly to a packaging material for precision electronic components, packaging material for food preservation, pharmaceutical packaging material, or backsheet material for use in solar cell modules, which requires airtightness and moisture resistance with low permeability to gases such as water vapor and oxygen.

### 2. Description of the Related Art

Recent years have witnessed a demand for plastic bodies, in particular films, having low gas permeability to water vapor, oxygen and the like, for sealing contents against the atmosphere, not only for applications in foodstuff and pharmaceutical products but also in other fields of industry.

Films having excellent gas-barrier property proposed hitherto include, for instance:
(A) A film obtained by lamination of a plastic film with a metal foil such as aluminum or the like (Japanese Unexamined Patent Application Laid-open Nos. H08-244790 and H09-2486).
(B) A film wherein a polymer resin composition having a high gas barrier property such as a copolymer of vinylidene chloride and/or ethylene vinyl alcohol is coated on a surface (Japanese Unexamined Patent Application Laid-open No. H07-266441).
(C) A film wherein aluminum and a ceramic such as silicon oxide, aluminum oxide or the like are vapor-deposited on a plastic film (Japanese Unexamined Patent Application Laid-open Nos. H06-23899, H06-128725 and H07-145256).
(D) A film obtained by laminating a film having gas barrier property, comprising a copolymer of ethylene vinyl alcohol, with a film comprising polyethylene and/or polypropylene (Japanese Unexamined Patent Application Laid-open Nos. H07-40516 and H10-193525), or
(E) Combinations of the foregoing (Japanese Unexamined Patent Application Laid-open Nos. H07-178788 and H10-72659).

Despite the excellent gas barrier property, the film in (A), where a plastic film is laminated with aluminum foil, is opaque and hence cannot be used in applications that require checking on the contents. The film cannot be disposed through incineration, and hence gives rise to further waste.

The film in (B), where a resin having gas barrier property is coated on a plastic film, the permeability to gases such as water vapor and oxygen is remarkably temperature-dependent. Also, films coated with vinylidene chloride contain chlorine, and are hence environmentally undesirable on account of the problem of noxious gas emissions during incineration after use.

In the film in (C), wherein aluminum and a ceramic such as silicon oxide, aluminum oxide or the like are vapor-deposited on a plastic film, increasing gas barrier property through a thicker film thickness results in lower pliability and/or transparency, which leads to problems such as cracking during manufacture and use, and loss of gas barrier property. If the film is too thin, gas barrier property is insufficient.

The film in (D) comprising a copolymer of ethylene vinyl alcohol and/or polyvinyl alcohol has low oxygen permeability, but suffers from the problem of lowered gas barrier property upon contact with water vapor. This problem, which was solved by laminating the film with a film of polyethylene and/or polypropylene having moderately low water vapor permeability, did not arguably succeed in affording gas barrier property.

The present inventors had already found out that providing a carbon layer on a polymer film enhances gas barrier property (Japanese Patent Application No. 2006-185638).

Although the gas barrier property of the film described in Japanese Patent Application No. 2006-185638 is sufficient, a step of laminating a different film was required.

The above methods are methods for imparting gas barrier property to a film, but it is evident that applying the same treatments to a film on a plastic substrate thicker than the film could result as well in improved barrier property. The value of the barrier property of thick plate-like films decreases in proportion to the thickness thereof, and hence, although achieving a practical gas barrier property is not a difficult problem, sometimes the barrier property is particularly required. The method of the present invention can be employed to meet the requirements of such applications.

In recent years, meanwhile, solar cells for solar power generation have attracted growing interest as an alternative energy to oil. Solar cells being realized at present include silicon (Group IV) solar cells and compound (Groups III-V, II-VII and the like) solar cells. The formers are broadly classified into crystalline silicon cells, amorphous silicon cells and hybrid silicon cells, which combine crystalline and amorphous silicon. The amount of material used in amorphous silicon wafers, which can be an order of magnitude thinner than silicon wafers of a crystalline cell having a thickness of 200 to 300 µm, is therefore advantageously small.

Amorphous cells are divided into those that use glass on a substrate of stacked amorphous layers, and those that use a film or stainless steel. Solar photovoltaic modules (cell aggregates) using a film or stainless steel on a substrate are lighter, afford easier wiring between cell layers, are more flexible and have a smaller heat capacity than modules using glass, and hence they can be obtained with high productivity, among other advantages.

Amorphous silicon solar cells using films comprise a plastic substrate upon which amorphous silicon is laminated. The cell structure of an amorphous silicon solar cell is basically that of a pn semiconductor junction, although p-i-n structures, wherein an i-layer having no dopants is sandwiched between pn layers with a view of enhancing the conversion efficiency from light to electricity, are becoming mainstream. The thickness of the cell is of about 200 to 400 nm for a single p-i-n structure (single junction cell). As required in a photovoltaic element, the cell must have constant thickness, be homogeneous, and be free of pinholes.

Although their "efficiency with which light is converted into electricity" decreases over time by several percent, amorphous silicon solar cells do not deteriorate otherwise, nor do they crystallize through the action of light (Photovoltaics, Yoshihiro Hamakawa, CMC, 2001 and Solar Cell Materials, Ceramic Society of Japan, Nikkan Kogyo Shimbun, Ltd., January 2006). We perfected the present invention focusing thus on such amorphous silicon films.

### SUMMARY OF THE INVENTION

In light of the above, it is an object of the invention to provide a transparent and flexible plastic substrate or plastic film having excellent gas barrier property.

The present invention is a plastic body imparted with gas barrier property, in terms of water vapor permeability and/or oxygen permeability, by comprising a plastic substrate or a plastic film upon at least one surface of which is formed with a layer comprising amorphous silicon, such a plastic body being thermally treated in the atmosphere with a view of further enhancing the gas barrier property.

The plastic substrate or plastic film of the present invention has excellent water vapor barrier property and oxygen barrier property. Accordingly, they can be used as a material in fields that require air tightness or gas barrier property for sealing against the atmosphere.

### BRIEF DESCRIPTION OF THE DRAWINGS

Fig. 1 is a diagram set illustrating comparatively the appearance of a polyester film depending on the thickness of an amorphous silicon layer;
Fig. 2 is a graph illustrating comparatively the water vapor permeability of a polyester film depending on the thickness of an amorphous silicon layer; and
Fig. 3 is a graph illustrating comparatively the oxygen permeability of a polyester film depending on the thickness of an amorphous silicon layer.

### DESCRIPTION OF THE PREFERRED EMBODIMENTS

As a result of diligent research on gas barrier plastic bodies, the inventors perfected the present invention upon finding that a material having excellent gas barrier property can be achieved at low cost by providing an amorphous silicon layer on one or both surfaces of a plastic substrate and a plastic film.

After the amorphous silicon layer is provided, the material of the present invention is subjected to a thermal treatment in the atmosphere to further improve gas barrier property (water vapor permeability and oxygen permeability).

The present invention is described in detail next.

As the plastic substrate or plastic film used in the present invention, which has a softening temperature of 70°C or higher, there can be employed plates or films obtained using as a raw material a thermoplastic resin such as polyethylene, polypropylene, polyvinyl chloride, polyvinylidene chloride or the like, or a plate or film obtained using as a raw material an engineering plastic such as nylon, a polyester (PET, PEN, PBT), a polyimide, polycarbonate or the like. The above organic polymers can be copolymerized or blended with small amounts of other organic polymers. The film, which is used usually as a packaging material, may be employed as a single-layer film or as a laminate of identical or different layers.

To these plastic substrates or plastic films there can be added UV absorbents, flame retardants and other arbitrary property-improving additives. Herein are excluded such additives that impair film properties through additive bleeding out of the film during the lamination step of the amorphous silicon layer.

A softening temperature of 70°C or higher is prescribed owing to the thermal treatment in the atmosphere that is carried out to further improve gas barrier property, after the amorphous silicon layer is provided. A softening temperature below 70°C results in softening of the plastic substrate or plastic film during heating, so that the effect of improving gas barrier property cannot be obtained. When no such improvement effect is required, the softening temperature is not crucial.

The plastic substrate or plastic film may be subjected to a pretreatment such as a corona discharge treatment, plasma treatment, or anchor coating treatment using isocyanate, polyethyleneimide, organic titanium or the like, to reform the plastic surface and enhance film adhesiveness.

When the object of the invention is a film, the latter must have a thickness ranging from 10 to 300 µm. Below 10 µm the film is too thin and has no strength, whereas beyond 300 µm the film is too thick to be defined as such. When restricted to a film, the thickness thereof ranges preferably from 20 to 200 µm. The method of the present invention can of course be used also when the object of the invention is a plate-like body, in which case the upper limit of the thickness thereof is not limited to 300 µm.

Methods for forming an amorphous silicon layer on at least one surface of a plastic substrate or a plastic film include, for instance, PVD (physical vapor deposition) such as vacuum vapor deposition, electron beams, sputtering, ion plating and the like as well as various CVD (chemical vapor deposition) methods such as normal-pressure CVD, where a thin film is formed through chemical reaction in gas phase, reduced-pressure CVD, plasma CVD, photo CVD, catalytic CVD and the like. The present invention is not limited to a particular method, and any of the foregoing methods can be selected depending on productivity and characteristic considerations.

Formation of a homogeneous film on a three-dimensional body is difficult in PVD, but the method affords excellent productivity on flat surfaces. On the other hand, CVD is not limited to flat surfaces, and enables formation of homogeneous films on three-dimensional bodies at low temperatures. The method used may be selected thus depending on the envisaged goals, with the foregoing in mind. Also, the raw material gases used in CVD are silane (gas) and hydrogen gas, so that the termini of the amorphous silicon comprise SiH groups. In PVD, where the bond termini are Si, SiH groups can be introduced through a hydrogen treatment, in order to stabilize the amorphous silicon layer.

As explained above, the basic structure of a photovoltaic amorphous silicon cell is p-i-n. Accordingly, the amorphous silicon layer of the present invention comprises layers that comprise, besides silicon, other metallic dopants such as phosphorus, germanium, boron, carbon and nitrogen. The amorphous silicon layer of the present invention may also be microcrystalline- amorphous silicon obtained by changing growth conditions to those of high hydrogen concentration.

However, intentional addition of such impurities, and/or film manufacture under high-concentration conditions are both cost-increasing factors, and hence are at variance with the object of the present invention, i.e. providing an inexpensive article.

In terms of gas barrier property and pliability, the thickness of the amorphous silicon layer ranges preferably from 10 to 200 nm, more preferably from 20 to 100 nm. A layer thickness below 10 nm impairs gas barrier property, whereas a thickness over 200 nm impairs transparency of the plastic film, thereby hampering visibility of contents, when the film of the invention is used as a packaging material. During processing, moreover, cracks may form in the amorphous silicon layer, which may impair gas barrier property.

Methods for subjecting to a thermal treatment in the atmospheric air the plastic substrate or plastic film whereon there is formed the amorphous silicon layer include, for instance, heating at a constant temperature, over a predetermined period of time, using conventional equipment such as a hot-air heating oven, a thermostat bath or the like. The temperature of the thermal treatment must be selected within a range from 70 to 140°C.

A thermal treatment temperature below 70°C is equivalent to not performing thermal treatment, as far as gas barrier property is concerned, whereas a thermal treatment temperature above 140°C is undesirable in that it may cause performance loss on account of, for instance, softening and/or shrinkage of the plastic substrate or the plastic film.

A significant discovery herein is the fact that the extremely small change in the composition of the amorphous silicon layer (Si + O₂ = SiO₂) observed before and after the thermal treatment does not impair gas barrier property, but, to the contrary, appears to enhance it.

The plastic substrate or plastic film of the present invention may be used without modification, as a single layer, but can also be suitably bonded (laminated) with other plastic substrates or plastic films for subsequent processing.

The plastic substrate or plastic film thus obtained, having formed thereon an amorphous silicon layer, has excellent gas barrier property, and can be used as a packaging material for electronic components that require air tightness, and as a gas barrier material for sealing against the atmosphere, in the form of a packaging material, for foodstuffs, pharmaceutical products and industrial materials.

### Examples

The present invention is described in detail below based on examples, although it is in no way meant to be limited to or by them.

In the examples below, water vapor permeability, oxygen permeability and appearance were measured and evaluated in accordance with the following methods.

<Water vapor permeability (g/m²·24 hrs)>: Water vapor permeability was measured in accordance with the method in JIS K7129 B, using a PERMATRAN-W3/33MG instrument by MOCON Ltd., at a temperature of 40°C and 90% relative humidity. The criterion for evaluation was a permeability not exceeding 3.

<Oxygen permeability (cc/m² ·24 hrs·atm)>: Oxygen permeability was measured in accordance with the method in JIS K7126 B, using an OX-OXRAN 2/21 MH instrument by MOCON Ltd., at a temperature of 25°C and 90% relative humidity. The criterion for evaluation was a permeability not exceeding 3.

<Appearance>: The film surface was inspected with naked eyes. Defective transparency was classed as poor.

### Examples 1 through 7

A polyester film (Ester film E-5100 by Toyobo Co.) having a thickness of 100 µm and subjected to corona treatment on one side was arranged inside the chamber of a plasma CVD apparatus, leaving a distance of 20 mm between the electrodes and the substrate film. While the interior of the chamber was kept at a reduced pressure of 80 Pa, the raw material gas was excited into plasma through the application of 140 W of power from a RF source at a frequency of 27.1 MHz, and then an amorphous silicon layer was formed by CVD at room temperature. The wetting index of the corona-treated surface of the polyester film was 54 mN/m.

Silane gas and hydrogen gas, which were used as the raw material gases, were introduced at flow rates of 300 sccm and 600 sccm, respectively. Herein, sccm denotes standard cc/min, which is a unit of gas introduced on rate into a vacuum apparatus.

The water vapor permeability, oxygen permeability and appearance of plastic films having an amorphous silicon layer of 10, 30 and 100 nm formed thereon (Examples 1 through 3) were evaluated. The results are given in Table 1.

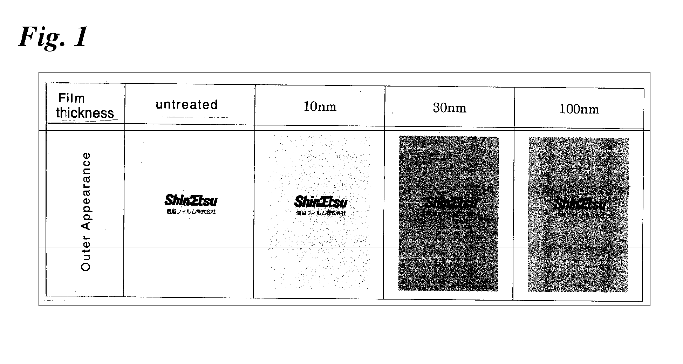

Fig. 1 illustrates photographs of the appearance of the surfaces.

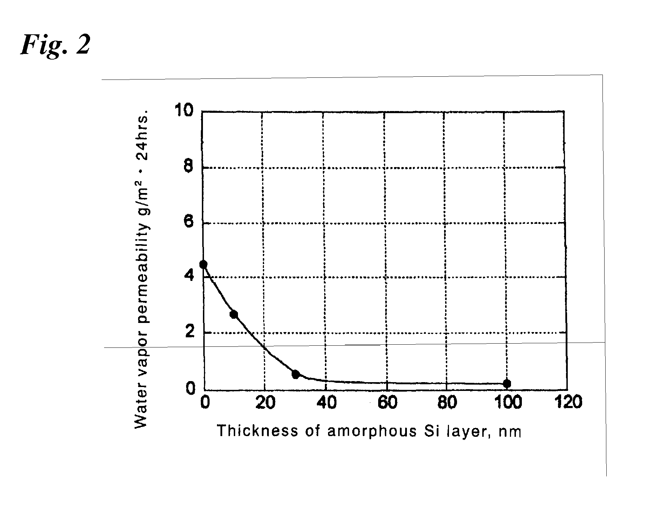

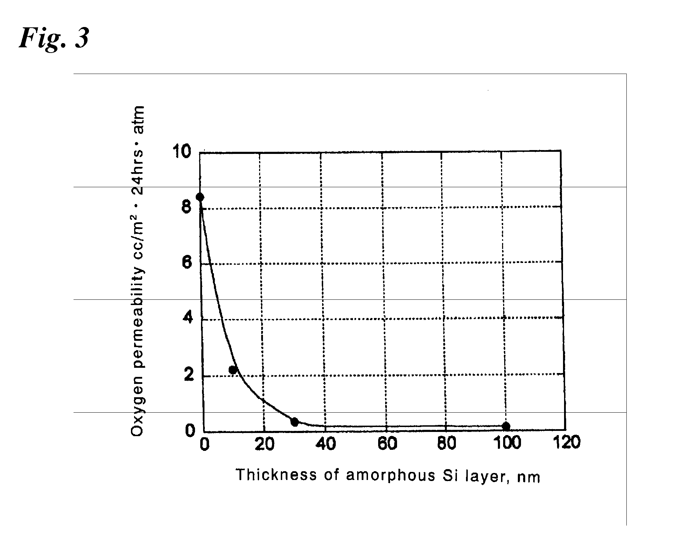

Fig. 2 (water vapor permeability) and Fig.3 (oxygen permeability) illustrate graphically the results of Table 1.

The polyester film having an amorphous silicon layer formed thereon obtained in Example 1 was placed in a hot-air drying oven heated beforehand to 80°C, and was kept standing under those conditions for 12 hours, after which the film was taken out of the oven (Examples 4, 5 and 7). The polyester film having a 30 nm-thick amorphous silicon layer was thermally treated with the temperature of the hot-air drying oven set to 120°C (Example 6). The water vapor permeability, oxygen permeability and appearance of the films were evaluated. The results are given also in Table 1.

### Comparative Examples

As Comparative Examples there were obtained a polyester film (Comparative Example 1) having no amorphous silicon layer formed thereon, and polyester films having an amorphous silicon layer formed thereon (Comparative Examples 2 and 3), using the same method as in Examples 1 through 3. The film thickness of the amorphous silicon layer is shown in Table 1. The water vapor permeability, oxygen permeability and appearance of the films were evaluated. The results are given also in Table 1.

**Table 1**

| Layer thickness and performance in the Examples and Comparative examples | | | | | | |
|---|---|---|---|---|---|---|
| | | Thickness, nm, of amorphous Si layer | Heat treatment at, °C | Water vapor permeability, g/m².24hrs. | Oxygen permeability, cc/m².hrs. | Outer appearance |
| Example | 1 | 10 | - | 2.67 | 2.22 | Good |
| | 2 | 30 | - | 0.57 | 0.36 | Good |
| | 3 | 100 | - | 0.24 | 0.17 | Good |
| | 4 | 10 | 80 | 0.75 | 0.79 | Good |
| | 5 | 30 | 80 | 0.28 | 0.36 | Good |
| | 6 | 30 | 120 | 0.29 | 0.27 | Good |
| | 7 | 100 | 80 | 0.19 | 0.20 | Good |
| Comparative Example | 1 | 0 | - | 4.47 | 8.43 | Good |
| | 2 | 5 | - | 3.92 | 6.14 | Good |
| | 3 | 200 | - | 0.11 | 0.06 | Poor (opaque) |

As shown in Table 1 and Figs. 2 and 3, providing an amorphous silicon layer has the effect of increasing gas barrier property, as compared with the case where no amorphous silicon layer was provided (Comparative Example 1 versus Examples 1 through 3).

Gas barrier property is improved further through thermal treatment (Examples 4 through 7).

When the amorphous silicon layer is excessively thick, at 200 nm (Comparative Example 3), the gas barrier property exhibits a superior value, but transparency decreases substantially through increased browning. Although a film thickness of 200 nm or more is carried in the fields that do not require transparency, the amorphous silicon layer thickness is preferably not larger than 200 nm in those fields where transparency is essential.

As described above, the gas barrier plastic film of the present invention is remarkably superior as regards water vapor blocking performance and oxygen blocking performance, and is highly valuable in manufacturing fields where such properties are required. The gas barrier plastic film of the present invention, which can be used as a packaging material for electronic components or the like that require air tightness, or as a gas barrier material for sealing against the atmosphere, has thus considerable industrial value.

## Claims

1. A gas barrier plastic body, comprising:
a plastic substrate; and
an amorphous silicon layer provided on at least one surface of the plastic substrate.

2. The gas barrier plastic body according to claim 1, wherein, after the amorphous silicon layer is provided to give a gas barrier plastic body, the gas barrier plastic body is subjected to a thermal treatment at 70 to 140°C in the atmospheric air.

3. A gas barrier plastic film, comprising:
a film-formed plastic substrate having a softening temperature of 70°C or higher and a thickness of 10 to 300 µm; and
an amorphous silicon layer having a thickness of 10 nm to 200 nm provided on at least one surface of the plastic substrate, wherein the oxygen permeability and the water vapor permeability after the amorphous silicon layer is provided are, respectively, 3 cc/m² 24 hrs·atm or lower and 3 g/m²·24 hrs or lower.

4. The gas barrier plastic film according to claim 3, wherein after the amorphous silicon layer is provided to give a gas barrier plastic film, the gas barrier plastic film is subjected to a thermal treatment at 70 to 140°C in the atmosphere.
